# EUROPÄISCHE PATENTSCHRIFT

(11) **EP 0 854 496 B1**
(45) Veröffentlichungstag und Bekanntmachung des Hinweises auf die Patenterteilung: **14.11.2001**
(21) Anmeldenummer: 98100230.6
(22) Anmeldetag: 08.01.1998
(51) Int. Cl.: H01J 61/56, H01J 5/62

(54) **Kompakte Niederdruckentladungslampe**
Compact low pressure discharge lamp
Lampe compacte à décharge basse pression

(30) Priorität: 15.01.1997 DE 19701162
(43) Veröffentlichungstag der Anmeldung: 22.07.1998
(73) Patentinhaber: Patent-Treuhand-Gesellschaft für elektrische Glühlampen mbH, 81543 München (DE)
(72) Erfinder: Wittmann, Horst, 86391 Stadtbergen (DE)

(56) Entgegenhaltungen:
- EP-A- 0 179 473
- EP-A- 0 447 957
- EP-A- 0 452 743
- DE-A- 19 501 417
- DE-U- 9 206 294
- PATENT ABSTRACTS OF JAPAN vol. 009, no. 263 (E-351), 19. Oktober 1985 & JP 60 109165 A (MATSUSHITA DENSHI KOGYO KK), 14. Juni 1985

## Beschreibung

Die Erfindung betrifft eine kompakte Niederdruckentladungslampe bestehend aus einem Entladungsgefäß mit Elektroden und Stromzuführungen und einem aus Kappe, Gehäuse und Montageplatte mit Vorschaltanordnung zusammengesetzten Sockel, wobei die Montageplatte mit der Vorschaltanordnung im Inneren des Sockelgehäuses angebracht ist und Anschlüsse zur elektrischen Verbindung der Stromzuführungen mit der Montageplatte aufweist.

Bekannte Niederdruckentladungslampen ersetzen in zunehmendem Maß die Glühlampe im Haus- und Wohnbereich. Bei den bekannten Niederdruckentladungslampen besteht das Entladungsgefäß meist aus einem ein- oder mehrfach gebogenen Rohr, welches in einem Sockel angeordnet ist. Im Sokkel ist dabei eine als Schaltungsplatine ausgebildete Montageplatte mit einer darauf verlöteten elektronischen Vorschaltanordnung integriert. Die Herstellungskosten für diese kompakten Niederdruckentladungslampen sind relativ hoch, da viele komplizierte Fertigungsschritte bei der Herstellung notwendig sind. Eine dieser Fertigungsschritte ist die elektrische Verbindung der Stromzuführungen des Entladungsgefäßes mit den entsprechenden Anschlüssen der Vorschaltanordnungen. Zur Herstellung dieser Verbindung werden bisher die entsprechenden Verbindungsdrähte zusammengeführt und zum Beispiel mit einer Metallhülse vercrimpt.

Eine Weiterentwicklung dieser einfachen Verbindung ist in der EP-A-0 452 743 beschrieben. Diese Druckschrift offenbart eine Niederdruckentladungslampe der eingangs beschriebenen Art, die Haltezapfen aufweist, mit deren Hilfe die Enden der Stromzuführungen senkrecht zu den bügelförmigen Anschlußdrähten der Vorschaltanordnung ausgerichtet sind. Beim Zusammenbau von Sockelgehäuse und Montageplatte mit der Sockelkappe werden die jeweiligen zu kontaktierenden Drähte etwa im rechten Winkel hintereinander angeordnet und mit Hilfe des Haltezapfens und der Innenwand des Sokkelgehäuses federnd gegeneinandergedrückt, so daß eine elektrische Verbindung zwischen den Elektroden des Entladungsgefäßes der Vorschaltanordnung hergestellt wird.

Nachteilig an diesem Stand der Technik ist jedoch, daß ein derartiges elektrisches Verbindungssystem sehr aufwendig ist. Dadurch erhöhen sich die Herstellungskosten. Zudem ist, um eine sichere Kontaktierung der Elemente zu gewährleisten, die Herstellungsgeschwindigkeit für derartige Niederdrukkentladungslampen nicht sehr hoch. Durch die Vielzahl von Bauteilen ergeben sich zusätzlich Platzprobleme innerhalb des Lampengehäuses. So sind z.B. Gehäuseverkleinerungen nicht durchführbar.

Es ist daher Aufgabe der Erfindung, eine kompakte Niederdruckentladungslampe der eingangs genannten Art bereitzustellen, bei der der für eine elektrische Verbindung der Stromzuführungen des Entladungsgefäßes mit den entsprechenden Anschlüssen der Vorschaltanordnung benötigte Aufbau einfach, platzsparend, schnell und kostengünstig unter Gewährleistung einer optimalen Kontaktsicherheit herzustellen ist.

Zur Lösung dieser Aufgabe dienen die Merkmale des unabhängigen Anspruches.

Vorteilhafte Ausgestaltungen sind in den Unteransprüchen beschrieben.

Bei einer erfindungsgemäßen kompakten Niederdruckentladungslampe sind die Stromzuführungen eines Entladungsgefäßes mit den elektrischen Anschlüssen einer Montageplatte mit Vorschaltanordnung über oder mittels jeweils einer elektrisch leitenden Schrauben- oder Spiralfeder verbunden, wobei die Kappe der Niederdruckentladungslampe mindestens eine Federaufnahme zur Aufnahme und lösbaren Befestigung der Schrauben- oder Spiralfeder aufweist. Durch die Verwendung einer Schrauben- oder Spiralfeder, welche einerseits an jeweils einer Stromzuführung und dem entsprechenden elektrischen Anschluss der Montageplatte anliegt oder andererseits die Stromzuführung gegen den entsprechenden elektrischen Anschluss drückt, ist eine sichere Kontaktierung gewährleistet. So werden beim Zusammenbau von Sockelgehäuse und Montageplatte mit der Sockelkappe die jeweiligen Federn entgegen dem wirksamen Federdruck sowohl an die Stromzuführungen wie auch die elektrischen Anschlüsse der Montageplatte gedrückt oder die Federn drücken die Stromzuführungen direkt gegen die entsprechenden Anschlüsse. Vorteilhafterweise wird erfindungsgemäß daher nur ein Element zur Verbindung der Stromzuführungen des Entladungsgefäßes mit den entsprechenden Anschlüssen der Montageplatte bzw. des Vorschaltgerätes benötigt. Dadurch verringern sich die Herstellungskosten deutlich. Zudem ergibt sich hieraus vorteilhafterweise eine deutliche Erhöhung der Herstellungsgeschwindigkeit, da bei dem Zusammenbau des Sockels der Niederdruckentladungslampe Sockelgehäuse und Sockelkappe lediglich aufeinandergedrückt werden müssen. Des weiteren steht durch die platzsparende Kontaktierung mehr Raum für mögliche weitere Bauteile zur Verfügung. Auch die Verkleinerung des gesamten Lampengehäuses wird vorteilhafterweise möglich.

Vor dem Zusammenbau des Sockels wird die Schrauben- oder Spiralfeder erfindungsgemäß in der Federaufnahme aufgenommen. Die Federaufnahme ist vorteilhafterweise am Innenumfang der Kappe ausgebildet und weist einen von einer üblicherweise im Querschnitt kreisförmig ausgebildeten Seitenwand gebildeten Hohlraum zur Aufnahme von zumindestens einem Teil der Feder auf. Dadurch können die Federn unabhängig von der Endmontage der Lampe montiert werden, was zu einer Vereinfachung des Herstellungsverfahrens beiträgt und somit die Herstellungskosten senkt. Des weiteren ist dadurch gewährleistet, dass eine einfache Wiederverwendung der Lampe oder des Elektronikteils, d.h. insbesondere der Montageplatte mit Vorschaltanordnung möglich ist. Neben einer vorteilhaften getrennt durchführbaren Funktionsprüfung von Lampe und Elektronikteil ist auch die getrennte Entsorgung dieser Bauelemente ohne Probleme durchführbar.

In einer weiteren vorteilhaften Ausgestaltung der erfindungsgemäßen Niederdruckentladungslampe weist die Seitenwand zwei parallel gegenüberliegende, zum freien Ende der Federaufnahme hin offene Schlitze zur Aufnahme der Stromzuführung auf. Im Bereich des kappenseitigen Schlitzes ist dabei eine Schulter in der Kappe ausgebildet. Diese dient zur Auflage eines Endes der Stromzuführung. Auch diese Merkmale tragen erfindungsgemäß zur Vereinfachung des Herstellungsprozesses der Lampe bei. So wird vor dem endgültigen Zusammenbau der Sockelkappe mit dem Sockelgehäuse das jeweilige Ende der Stromzuführungen des Entladungsgefäßes in die offenen Schlitze der Seitenwand der Federaufnahme und auf die Schulter gelegt. Wird nunmehr die Feder auf das Ende der Stromführung gesetzt, so drückt diese das Ende der Stromzuführung in den Hohlraum der Federaufnahme sowie in einen die Schulter umgebenden Hohlraum, wobei die Stromzuführung auf der Schulter und in dem Schlitz der Federaufnahme zu liegen kommt. Da das andere Ende der Feder durch die Montageplatte niedergehalten wird, ist eine einfache und sichere elektrische Verbindung zwischen der Schrauben- oder Spiralfeder und der Stromzuführung einerseits sowie den entsprechenden elektrischen Anschlüssen auf der Montageplatte gewährleistet.

In einer weiteren vorteilhaften Ausführungsform der erfindungsgemäßen Niederdruckentladungslampe werden die Federn ebenfalls durch in entsprechenden am Innenumfang der Kappe ausgebildeten Federaufnahmen aufgenommen. Die Federaufnahmen weisen hierzu ebenfalls einen von der üblicherweise im Querschnitt kreisförmig ausgebildeten Seitenwand gebildeten Hohlraum zur Aufnahme von zumindestens einem Teil der Feder auf. Allerdings ist bei diesem Ausführungsbeispiel die Seitenwand der Federaufnahme in einem Teilbereich verlängert ausgebildet, derart, daß des Ende des Teilbereichs über die Montageplatte hinaus bzw. hindurch in den Bereich der Vorschaltanordnung ragt, wobei im Teilbereich ein Schlitz zur Aufnahme der Stromzuführung ausgebildet ist. Auch diese Merkmale tragen erfindungsgemäß zur Vereinfachung des Herstellungsprozesses der Lampe bei. So wird vor dem endgültigen Zusammenbau der Sockelkappe mit dem Sokkelgehäuse das jeweilige Ende der Stromzuführungen des Entladungsgefäßes in den offenen Schlitz des verlängerten Teilbereiches der Seitenwand der Federaufnahme gelegt und gedrückt. Wird nunmehr die Feder auf das Ende der Stromführung gesetzt, so drückt diese das Ende der Stromzuführung auf den elektrischen Anschluß der Montageplatte. Somit ist eine einfache und sichere elektrische Verbindung zwischen der Stromzuführung sowie den entsprechenden elektrischen Anschlüssen auf der Montageplatte gewährleistet.

Die Länge der Schrauben- oder Spiralfeder ist zudem derart gewählt, daß eine sichere Kontaktierung der Stromzuführung mit dem Anschluß der Montageplatte gewährleistet ist.

Die Schrauben- oder Spiralfeder besteht üblicherweise aus einer gut leitenden Metallegierung. Ein zusätzliches Verzinnen der Federn ist möglich.

In einer weiteren vorteilhaften Ausgestaltung des Erfindungsgegenstandes ist die Stromzuführung und die Feder einstückig ausgebildet. Da sich hierbei die Anzahl der die elektrische Verbindung ausbildenden Elemente verringert, ist eine weitere Vereinfachung des Herstellungsprozesses möglich.

In einer weiteren vorteilhaften Ausgestaltung der erfindungsgemäßen Niederdruckentladungslampe ist die Montageplatte senkrecht zur Lampenlängsachse im Inneren des Gehäuses befestigt. Die Montageplatte liegt dabei auf am Innenumfang des Gehäuses ausgebildeten Rippen, die parallel zur Lampenlängsachse verlaufen, auf. Vorteilhafterweise ist die Montageplatte als Platine ausgebildet, wobei an der dem Entladungsgefäß zugewandten Seite Leiterbahnen und auf der dem Entladungsgefäß abgewandten Seite Schaltungselemente der Vorschaltanordnung ausgebildet sind. Dabei ist mindestens ein Anschluß zur elektrischen Kontaktierung der Stromzuführung mit der Montageplatte als Lötauge ausgebildet. In einer weiteren vorteilhaften Ausbildung besteht mindestens ein Anschluß zur elektrischen Kontaktierung der Stromzuführung mit der Montageplatte aus einer oder mehrerer flacher Lötflächen und/oder -streifen. Durch diesen einfachen und platzsparenden Aufbau des Sockels der Lampe ist gewährleistet, daß dieser insgesamt klein gehalten werden kann und auch kostengünstig herzustellen ist.

Zur lagerichtigen Positionierung der Kappe und des Gehäuses des Sockels sind vorteilhafterweise Positionierungsvorrichtungen ausgebildet.

Weitere Einzelheiten, Merkmale, Ausgestaltungen und Vorteile ergeben sich aus der folgenden Beschreibung mehrerer zeichnerisch dargestellter Ausführungsbeispiele des Erfindungsgegenstandes:

Darin zeigen
- Figur 1: eine schematisch dargestellte, teilweise geschnittene Seitenansicht der erfindungsgemäßen Niederdruckentladungslampe;
- Figur 2: eine schematisch dargestellte, teilweise geschnittene seitliche Detailansicht der erfindungsgemäßen Niederdruckentladungslampe;
- Figur 3: eine schematisch dargestellte Aufsicht auf den Sockel der erfindungsgemäßen Niederdruckentladungslampe;
- Figur 4: eine schematisch dargestellte Aufsicht auf einen Teil des Randbereiches des Sockels der erfindungsgemäßen Niederdruckentladungslampe;
- Figur 5: eine schematisch dargestellte, teilweise geschnittene Seitenansicht einer zweiten Ausführungsform der erfindungsgemäßen Niederdruckentladungslampe;
- Figur 6: eine schematisch dargestellte, teilweise geschnittene seitliche Detailansicht der erfindungsgemäßen Niederdruckentladungslampe gemäß Figur 5;
- Figur 7: eine schematisch dargestellte weitere Detailansicht des Randbereiches der erfindungsgemäßen Niederdruckentladungslampe gemäß Figur 5; und
- Figur 8: eine schematisch dargestellte Aufsicht auf den Sockel der erfindungsgemäßen Niederdruckentladungslampe gemäß Figur 5.

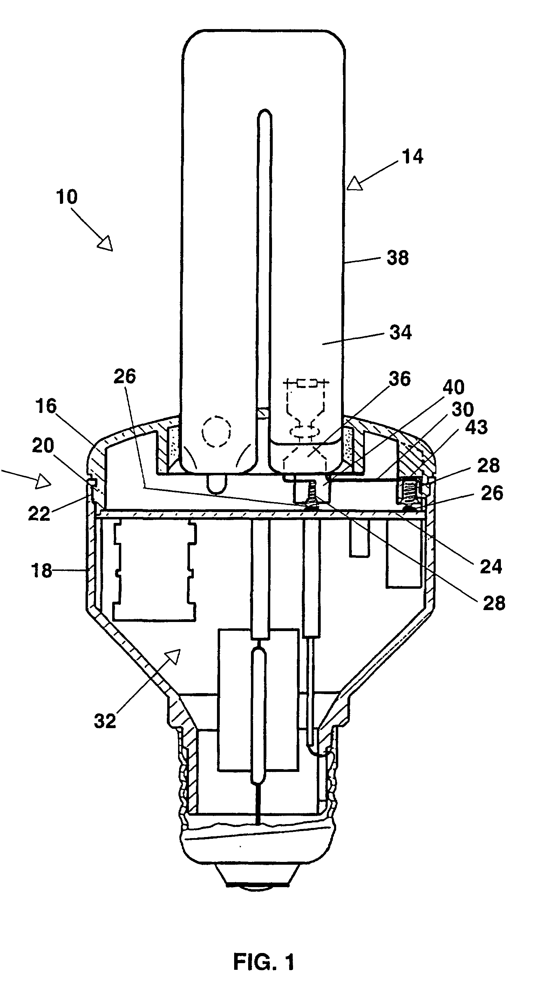

In Figur 1 ist eine teilweise geschnittene Seitenansicht einer erfindungsgemäßen kompakten Niederdruckentladungslampe 10 wiedergegeben. Die Lampe 10 umfaßt dabei ein Entladungsgefäß 14 und einen Sockel 12, wobei der Sockel 12 aus einer Kappe 16 und einem Gehäuse 18 zusammengesetzt ist. Der Sockel 12 ist dabei im wesentlichen zylinderförmig ausgebildet. Die Kappe 16 und das Gehäuse 18 sind lösbar miteinander verbunden, wobei mindestens eine Positioniervorrichtung (nicht dargestellt) zur lagerichtigen Verbindung der Kappe 16 und des Gehäuses 18 ausgebildet ist. Die Kappe 16 weist dabei in dem dem Gehäuse 18 zugewandten Ende eine ringförmige Wulst 20 in ihrem Außenumfang auf. Die Wulst 20 greift dabei in eine entsprechende Ringnut 22 im Innenumfang des Gehäuses 18 ein. Durch Aufschnappen des inneren Randes des Gehäuses 18 auf den äußeren Rand der Kappe 16 wird eine sichere Verbindung zwischen den beiden Teilen hergestellt.

Im Inneren des im wesentlichen zylindrisch ausgebildeten Gehäuses 18 ist eine Montageplatte 24 senkrecht zur Lampenlängsachse befestigt. Die Montageplatte 24 ist als Platine ausgebildet, wobei an der dem Entladungsgefäß 14 zugewandten Seite Leiterbahnen und auf der dem Entladungsgefäß 14 abgewandten Seite Schaltungselemente der Vorschaltanordnung 32 ausgebildet sind. Am Innenumfang des Gehäuses 18 sind zudem Rippen 58 ausgebildet, die parallel zur Lampenlängsachse verlaufen und auf deren Enden die Montageplatte 24 aufliegt.

Das Entladungsgefäß 14 besteht üblicherweise aus zwei oder drei U-förmig gebogenen Rohrstücken, die durch einen Durchlaß miteinander verbunden sind, wobei jeweils die Endschenkel Elektroden tragen. Die freien Enden der Rohrstücke 38 bzw. der Kolben 34 sind durch Quetschungen 36 gasdicht verschlossen und sitzen innerhalb der Kappe 16 des Sockels 12. Im Bereich der Quetschungen 36 treten Stromzuführungen 30 aus dem Entladungsgefäß 14 aus. Die Stromzuführungen 30 sind mit den elektrischen Anschlüssen 26 der Montageplatte 24 über jeweils eine elektrisch leitende Schrauben- oder Spiralfeder 28 verbunden. Die Feder 28 greift dabei in eine am Innenumfang der Kappe 16 ausgebildete Federaufnahme 40 ein und ist in dem gezeigten Ausführungsbeispiel lösbar darin befestigt.

Die Federaufnahme 40 besteht aus einer im Querschnitt ungefähr kreisförmig ausgebildeten Seitenwand 43, die einen Hohlraum 42 umgibt. Der Hohlraum 42 dient zur Aufnahme eines Teils der Feder 28.

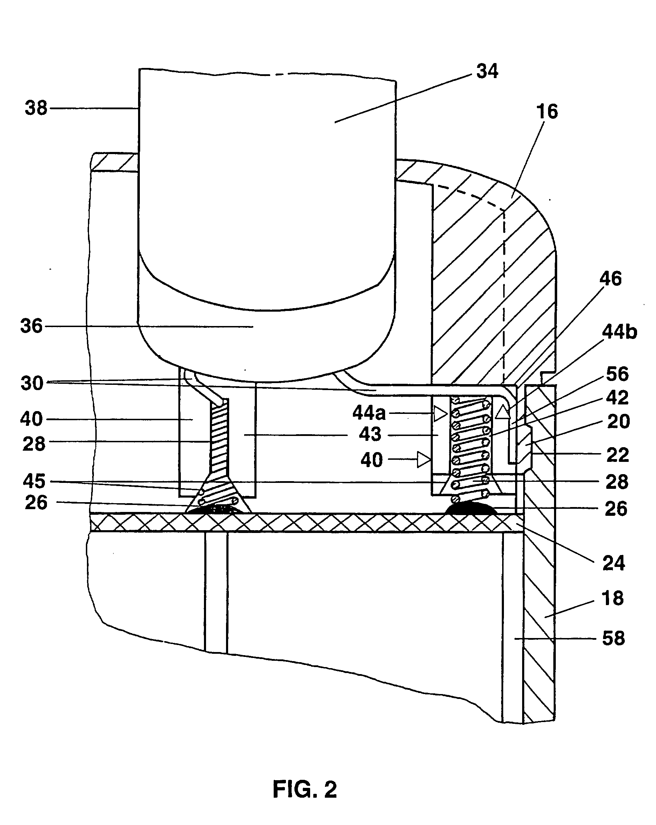

Figur 2 zeigt eine schematisch dargestellte, teilweise geschnittene seitliche Detailansicht der Niederdruckentladungslampe 10. Man erkennt, daß die Schrauben- oder Spiralfeder 28 für den Kontaktschluß zwischen der Stromzuführung 30 und dem Anschluß 26 zu liegen kommt. Die Stromzuführungen 30 bestehen üblicherweise aus zwei Komponenten, nämlich Vakuvit und verzinktem Draht und weisen einen Durchmesser von ca. 0,4 mm auf. Die Seitenwand 43 weist zwei parallel gegenüberliegende, zum freien Ende der Federaufnahme 40 hin offene Schlitze 44a, 44b zur Aufnahme der Stromzuführung 30 auf. Im Bereich des kappenseitigen Schlitzes 44b ist eine Schulter 46 in der Kappe 16 ausgebildet. Diese dient zur Auflage eines Endes 56 der Stromzuführung 30, daß beim Zusammenbau der Kappe 16 mit dem Gehäuse 18 gegen den Innenumfang der Kappe 16 und den dort ausgebildeten Hohlraum gedrückt wird.

Zudem weist die den Hohlraum 42 umgebende Seitenwand 43 zum freien Ende der Federaufnahme 40 hin Abschrägungen 45 auf. Diese Abschrägungen 45 erleichtern die Einführung der Feder 28 und der Stromzuführung 30.

Weiterhin erkennt man, daß die Montageplatte 24 auf der dem Entladungsgefäß 14 zugewandten Seite Anschlüsse 26 zur elektrischen Kontaktierung der Stromzuführungen 30 der Vorschaltanordnung 32 aufweist. Die Anschlüsse 26 können dabei als Lötauge oder auch als flache in die Montageplatte 24 integrierte Lötflächen und/oder -streifen ausgebildet sein.

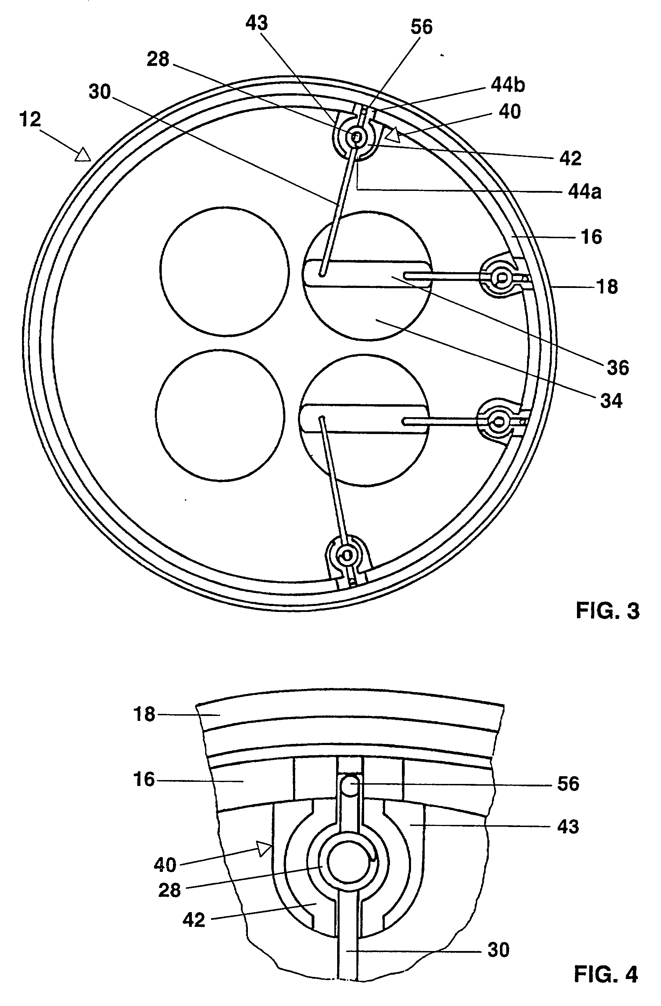

In den Figuren 3 und 4 ist eine Aufsicht auf den Sockel 12 der Niederdrukkentladungslampe 10 dargestellt. Man erkennt, daß das freie Ende des Gehäuses 18 mit dem freien Ende der Kappe 16 verbunden ist. Am Innenumfang der Kappe 16 sind die Federaufnahmen 40 ausgebildet. Die Federaufnahme 40 ist dabei im Querschnitt im wesentlichen kreisförmig ausgebildet. Auch die achsengleiche parallele Lage der Schlitze 44a und 44b ist gut erkennbar. Es wird zudem deutlich, daß die Feder 28 auf der Stromzuführung 30 aufliegt. Die Stromzuführung 30 ist in den Schlitzen 44a und 44b geführt, wobei das Ende 56 der Stromzuführung 30 auf der Schulter 46 aufliegt und in einen in der Kappe 16 ausgebildeten Hohlraum gegen den Innenumfang der Kappe 16 gedrückt wird.

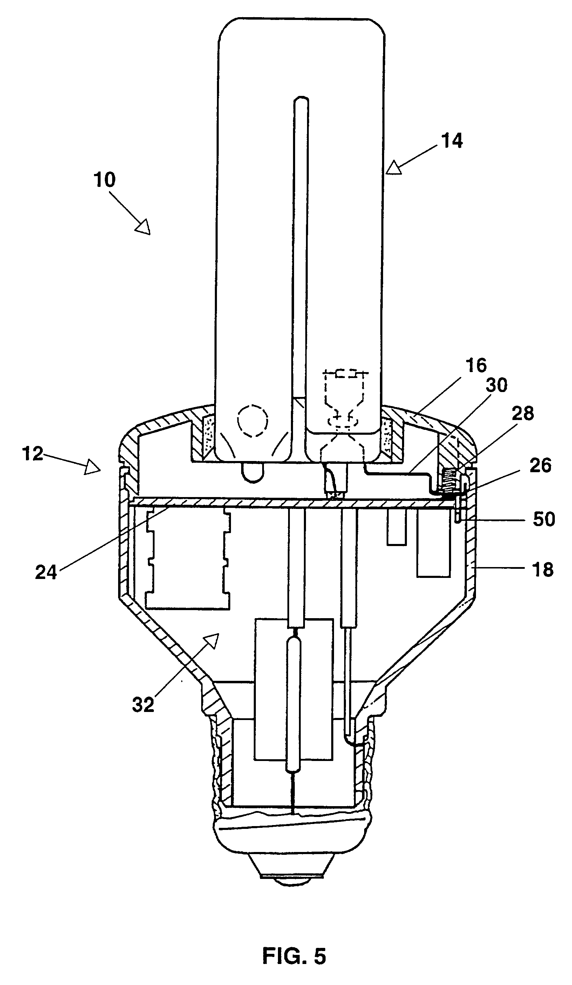

Figur 5 zeigt eine schematisch dargestellte, teilweise geschnittene Seitenansicht einer zweiten Ausführungsform der Niederdruckentladungslampe 10. Der Aufbau dieser Lampe 10 entspricht dabei im wesentlichen dem der in den Figuren 1 bis 4 beschriebenen. Auch bei diesem Ausführungsbeispiel sind am Innenumfang der Kappe 16 Federaufnahmen 40 zur Aufnahme und lösbaren Befestigung der Schrauben- oder Spiralfedern 28 angeordnet. Auch weisen die Federaufnahmen 40 jeweils einen durch eine im Querschnitt ungefähr kreisförmig gestaltete Seitenwand 43 ausgebildeten Hohlraum 42 auf. Im Unterschied zu der erstbeschriebenen Ausführungsform drücken hier die Schrauben- oder Spiralfedern 28 die Stromzuführungen 30 direkt gegen die entsprechenden elektrischen Anschlüsse 26 der Montageplatte 24.

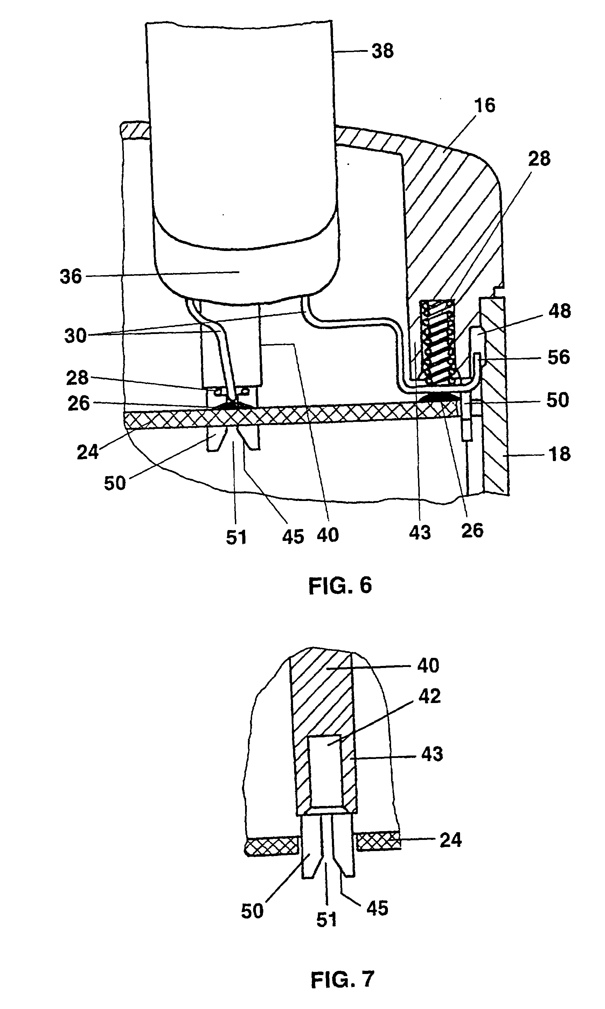

Die Detaildarstellungen gemäß den Figuren 6 und 7 zeigen, daß die Seitenwand 43 der Federaufnahme 40 in einem Teilbereich 50 verlängert ausgebildet ist, derart, daß das Ende des Teilbereichs 50 der Seitenwand 43 über die Montageplatte 24 hinaus bzw. hindurch in den Bereich der Vorschaltanordnung 32 ragt, wobei im Teilbereich 50 ein Schlitz 51 zur Aufnahme der Stromzuführung 30 ausgebildet ist. Bei dem Zusammenbau der Sockelkappe 16 mit dem Sockelgehäuse 18 wird das jeweilige Ende der Stromzuführungen 30 des Entladungsgefäßes 14 in den offenen Schlitz 51 des verlängerten Teilbereiches 50 der Seitenwand 43 der Federaufnahme 40 gelegt und gedrückt. Die Feder 28 drückt dann das Ende der Stromzuführung 30 auf den elektrischen Anschluß 26 der Montageplatte 24. Die Anschlüsse 26 können auch hier jeweils als Lötauge oder auch als flache in die Montageplatte 24 integrierte Lötflächen und/oder -streifen ausgebildet sein. Die Einführung der Stromzuführung 30 in den Schlitz 51 wird durch entsprechende Abschrägungen 45 der Seitenwand 50 am freien Ende der Federaufnahme 40 erleichtert. Weiterhin erkennt man, daß zwischen dem Innenumfang des Gehäuses 18 und der Federaufnahme 40 ein Spalt 48 ausgebildet ist. Der Spalt 48 dient zur Aufnahme des Endes 56 der Stromzuführung 30.

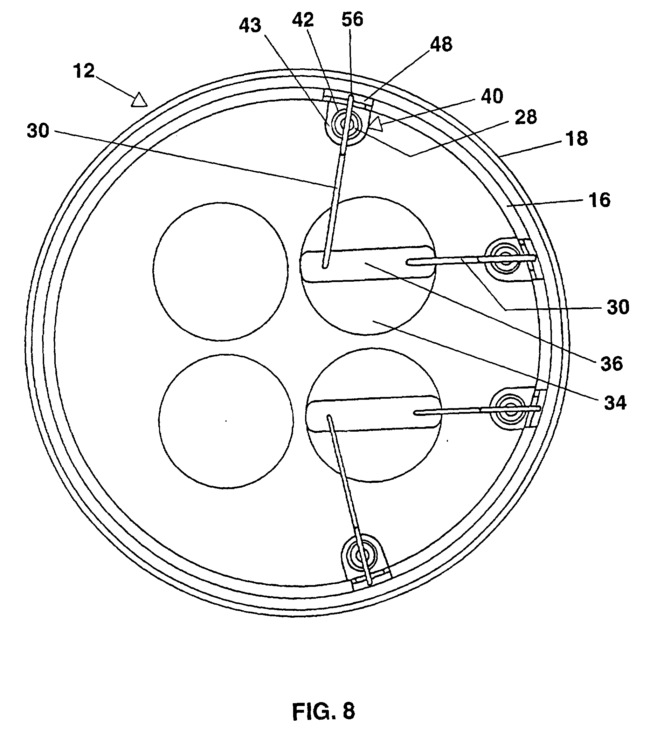

In Figur 8 ist eine Aufsicht auf den Sockel 12 der Niederdruckentladungslampe 10 dargestellt. Man erkennt, daß das freie Ende des Gehäuses 18 mit dem freien Ende der Kappe 16 verbunden ist. Am Innenumfang der Kappe 16 sind die Federaufnahmen 40 ausgebildet. Die Federaufnahmen 40 sind dabei im Querschnitt im wesentlichen kreisförmig ausgebildet. Es wird zudem deutlich, daß die Stromzuführungen 30 jeweils auf den freien Enden der Federaufnahmen 40 aufliegen. Die Stromzuführung 30 ist in dem Schlitz 51 geführt, wobei das Ende 56 der Stromzuführung 30 in dem Spalt 48 zu liegen kommt.

Die verwendeten Federn 28 bestehen überwiegend aus einer gut leitfähigen Metallegierung. Zusätzlich ist eine zumindest teilweise Verzinnung und/oder Verzinkung der Feder 28 möglich. Die Steigung der Schrauben- oder Spiralfeder 28 ist kleiner als der Durchmesser der Feder.

In einem weiteren, nicht dargestellten Ausführungsbeispiel ist vorgesehen, daß die Stromzuführung 30 und die Feder 28 einstückig ausgebildet sind.

## Patentansprüche

1. Kompakte Niederdruckentladungslampe bestehend aus einem Entladungsgefäß (14) mit Elektroden und Stromzuführungen (30) und einem aus Kappe (16), Gehäuse (18) und Montageplatte (24) mit Vorschaltanordnung (32) zusammengesetzten Sockel (12), wobei die Montageplatte (24) mit der Vorschaltanordnung (32) im Inneren des Sockelgehäuses (18) angebracht ist und Anschlüsse (26) zur elektrischen Verbindung der Stromzuführungen (30) mit der Montageplatte (24) aufweist, **dadurch gekennzeichnet, dass** die Stromzuführungen (30) mit den elektrischen Anschlüssen (26) der Montageplatte (24) über oder mittels jeweils einer elektrisch leitenden Schrauben- oder Spiralfeder (28) verbunden sind und die Kappe (16) mindestens eine Federaufhahme (40) zur Aufnahme und lösbaren Befestigung der Schrauben- oder Spiralfeder (28) aufweist.

2. Niederdruckentladungslampe nach Anspruch 1, **dadurch gekennzeichnet, dass** die Schrauben- oder Spiralfeder (28) für den Kontaktschluss zwischen der Stromzuführung (30) und dem Anschluss (26) zu liegen kommt.

3. Niederdruckentladungslampe nach Anspruch 1, **dadurch gekennzeichnet, dass** die Schrauben- oder Spiralfeder (28) für den Kontaktschluss die Stromzuführung (30) gegen den Anschluss (26) drückt.

4. Niederdruckentladungslampe nach Anspruch 2, **dadurch gekennzeichnet, dass** die Federaufhahme (40) am Innenumfang der Kappe (16) ausgebildet ist.

5. Niederdruckentladungslampe nach Anspruch 4, **dadurch gekennzeichnet, dass** die Federaufhahme (40) einen Hohlraum (42) zur Aufnahme eines Teils der Schrauben- oder Spiralfeder (28) aufweist, der von einer im Querschnitt kreisförmigen Seitenwand (43) ausgebildet wird.

6. Niederdruckentladungslampe nach Anspruch 5, **dadurch gekennzeichnet, dass** die Seitenwand (43) zwei parallel gegenüberliegende, zum freien Ende der Federaufnahme (40) offene Schlitze (44a, 44b) zur Aufnahme der Stromzuführung (30) aufweist.

7. Niederdruckentladungslampe nach Anspruch 6, **dadurch gekennzeichnet, dass** im Bereich des Schlitzes (44b) eine Schulter (46) in der Kappe (16) zur Auflage eines Endes (56) der Stromzuführung (30) ausgebildet ist.

8. Niederdruckentladungslampe nach Anspruch 3, **dadurch gekennzeichnet, dass** die Federaufnahme (40) am Innenumfang der Kappe (16) ausgebildet ist.

9. Niederdruckentladungslampe nach Anspruch 8, **dadurch gekennzeichnet, dass** die Federaufnahme (40) einen Hohlraum (42) zur Aufnahme eines Teils der Schrauben- oder Spiralfeder (28) aufweist, der von einer im Querschnitt kreisförmigen Seitenwand (43) ausgebildet wird.

10. Niederdruckentladungslampe nach einem der Ansprüche 8 oder 9, **dadurch gekennzeichnet, dass** zwischen dem Innenumfang des Gehäuses (18) und der Federaufnahme (40) ein Spalt (48) zur Aufnahme eines Endes (56) der Stromzuführung (30) ausgebildet ist.

11. Niederdruckentladungslampe nach einem der vorhergehenden Ansprüche 8 bis 10, **dadurch gekennzeichnet, dass** die Seitenwand (43) der Federaufnahme (40) in einem Teilbereich (50) verlängert ausgebildet ist, derart, dass das Ende des Teilbereichs (50) der Seitenwand (43) über die Montageplatte (24) hinaus bzw. hindurch in den Bereich der Vorschaltanordnung (32) ragt, wobei im Teilbereich (50) ein Schlitz (51) zur Aufnahme der Stromzuführung (30) ausgebildet ist.

12. Niederdruckentladungslampe nach einem der vorhergehenden Ansprüche, **dadurch gekennzeichnet, dass** die den Hohlraum (42) umgebende Seitenwand (43) zum freien Ende der Federaufnahme (40) hin Abschrägungen (45) aufweist.

13. Niederdruckentladungslampe nach einem der vorhergehenden Ansprüche, **dadurch gekennzeichnet, dass** die Feder (28) aus einer gut leitfähigen Metalllegierung besteht.

14. Niederdruckentladungslampe nach einem der vorhergehenden Ansprüche, **dadurch gekennzeichnet, dass** die Länge der Feder (48) derart gewählt ist, dass eine sichere Kontaktierung mit dem Anschluss (26) der Montageplatte (24) gewährleistet ist.

15. Niederdruckentladungslampe nach einem der vorhergehenden Ansprüche, **dadurch gekennzeichnet, dass** der Sockel (12) im wesentlichen zylinderförmig ausgebildet ist.

16. Niederdruckentladungslampe nach einem der vorhergehenden Ansprüche, **dadurch gekennzeichnet, dass** die Kappe (16) und das Gehäuse (18) lösbar miteinander verbunden sind, wobei mindestens eine Positioniervorrichtung zur lagerichtigen Verbindung von Kappe (16) und Gehäuse (18) ausgebildet ist.

17. Niederdruckentladungslampe nach einem der vorhergehenden Ansprüche, **dadurch gekennzeichnet, dass** die Montageplatte (24) senkrecht zur Lampenlängsachse im Inneren des Gehäuses (18) befestigt ist.

18. Niederdruckentladungslampe nach einem der vorhergehenden Ansprüche, **dadurch gekennzeichnet, dass** am Innenumfang des Gehäuses (18) Rippen (58) ausgebildet sind, die parallel zur Lampenlängsachse verlaufen und auf deren Enden die Montageplatte (24) aufliegt.

19. Niederdruckentladungslampe nach einem der vorhergehenden Ansprüche, **dadurch gekennzeichnet, dass** die Montageplatte (24) als Platine ausgebildet ist, wobei an der dem Entladungsgefäß (14) zugewandten Seite Leiterbahnen und auf der dem Entladungsgefäß (14) abgewandten Seite Schaltungselemente der Vorschaltanordnung (32) ausgebildet sind.

20. Niederdruckentladungslampe nach einem der vorhergehenden Ansprüche, **dadurch gekennzeichnet, dass** mindestens ein Anschluss (26) zur elektrischen Kontaktierung der Stromzuführungen (30) mit der Montageplatte (24) als Lötauge ausgebildet ist.

21. Niederdruckentladungslampe nach einem der vorhergehenden Ansprüche, **dadurch gekennzeichnet, dass** mindestens ein Anschluss (26) zur elektrischen Kontaktierung der Stromzuführungen (30) mit der Montageplatte (24) aus einer oder mehreren flachen Lötflächen und/oder -streifen besteht.

22. Niederdruckentladungslampe nach einem der vorhergehenden Ansprüche, **dadurch gekennzeichnet, dass** die Stromzuführung (30) und die Feder (28) einstückig ausgebildet sind.

## Claims

1. Compact low-pressure discharge lamp comprising a discharge vessel (14) having electrodes and supply leads (30) and having a lamp cap (12) assembled from a cap (16), housing (18) and mounting plate (24) with a ballast arrangement (32), the mounting plate (24) with the ballast arrangement (32) being fitted in the interior of the lamp cap housing (18) and having terminals (26) for the electric connection of the supply leads (30) to the mounting plate (24), **characterized in that** the supply leads (30) are connected to the electric terminals (26) of the mounting plate (24) via or by means of an electrically conducting helical or spiral spring (28) in each case, and the cap (16) has at least one spring receptacle (40) for receiving and detachably fastening the helical or spiral spring (28).

2. Low-pressure discharge lamp according to claim 1, **characterized in that** the helical or spiral spring (28) for contact closure comes to lie between the supply lead (30) and the terminal (26).

3. Low-pressure discharge lamp according to Claim 1, **characterized in that** the helical or spiral spring (28) for contact closure presses the supply lead (30) against the terminal (26).

4. Low-pressure discharge lamp according to Claim 2, **characterized in that** the spring receptacle (40) is constructed on the inner circumference of the cap (16).

5. Low-pressure discharge lamp according to Claim 4, **characterized in that** the spring receptacle (40) has a cavity (42) for receiving a part of the helical or spiral spring (28), which cavity is constructed by a side wall (43) of circular cross section.

6. Low-pressure discharge lamp according to Claim 5, **characterized in that** the side wall (43) has two parallel, opposite slots (44a, 44b), open towards the free end of the spring receptacle (40), for receiving the supply lead (30).

7. Low-pressure discharge lamp according to Claim 6, **characterized in that** in the region of the slot (44b) a shoulder (46) is constructed in the cap (16) for supporting an end (56) of the supply lead (30).

8. Low-pressure discharge lamp according to Claim 3, **characterized in that** the spring receptacle (40) is constructed on the inner circumference of the cap (16).

9. Low-pressure discharge lamp according to Claim 8, **characterized in that** the spring receptacle (40) has a cavity (42) for receiving a part of the helical or spiral spring (28), which cavity is constructed by a side wall (43) of circular cross section.

10. Low-pressure discharge lamp according to either of Claims 8 or 9, **characterized in that** a gap (48) for receiving an end (56) of the supply lead (30) is constructed between the inner circumference of the housing (18) and the spring receptacle (40).

11. Low-pressure discharge lamp according to one of the preceding Claims 8 to 10, **characterized in that** the side wall (43) of the spring receptacle (40) is constructed in a lengthened fashion in a subregion (50) in such a way that the end of the subregion (50) of the side wall (43) projects beyond the mounting plate (24) or through into the region of the ballast arrangement (32), a slot (51) being formed in the subregion (50) for the purpose of receiving the supply lead (30).

12. Low-pressure discharge lamp according to one of the preceding claims, **characterized in that** the side wall (43) surrounding the cavity (42) has bevels (45) towards the free end of the spring receptacle (40).

13. Low-pressure discharge lamp according to one of the preceding claims, **characterized in that** the spring (28) consists of a metal alloy which is a good conductor.

14. Low-pressure discharge lamp according to one of the preceding claims, **characterized in that** the length of the spring (48) is selected so as to ensure reliable contact with the terminal (26) of the mounting plate (24).

15. Low-pressure discharge lamp according to one of the preceding claims, **characterized in that** the lamp cap (12) is essentially of cylindrical construction.

16. Low-pressure discharge lamp according to one of the preceding claims, **characterized in that** the cap (16) and the housing (18) are detachably connected to one another, at least one positioning device being constructed by connecting the cap (16) and housing (18) in the correct position.

17. Low-pressure discharge lamp according to one of the preceding claims, **characterized in that** the mounting plate (24) is fastened perpendicular to the longitudinal lamp axis in the interior of the housing (18).

18. Low-pressure discharge lamp according to one of the preceding claims, **characterized in that** constructed on the inner circumference of the housing (18) are ribs (58) which run parallel to the longitudinal lamp axis and on whose ends the mounting plate (24) rests.

19. Low-pressure discharge lamp according to one of the preceding claims, **characterized in that** the mounting plate (24) is constructed as a printed circuit board, conductor tracks being constructed on the side facing the discharge vessel (14), and circuit elements of the ballast arrangement (32) being constructed on the side averted from the discharge vessel (14).

20. Low-pressure discharge lamp according to one of the preceding claims, **characterized in that** at least one terminal (26) is constructed as a soldering eyelet for the purpose of making electric contact between the supply leads (30) and the mounting plate (24).

21. Low-pressure discharge lamp according to one of the preceding claims, **characterized in that** at least one terminal (26) comprises one or more flat soldering surfaces and/or solder tag strips for the purpose of making electric contact between the supply leads (30) and the mounting plate (24).

22. Low-pressure discharge lamp according to one of the preceding claims, **characterized in that** the supply lead (30) and the spring (28) are constructed in one piece.

## Revendications

1. Lampe compacte à décharge basse pression, constituée d'une enceinte (14) de décharge ayant des électrodes et des entrées (30) de courant, et d'un culot (12) constitué d'un couvercle (16), d'un corps (18) et d'une plaque (24) de montage à dispositif (32) de ballast, la plaque (24) de montage, ayant le dispositif (32) de ballast, étant disposée à l'intérieur du corps (18) du culot et comportant des bornes (26) pour la liaison électrique des entrées (30) de courant à la plaque (24) de montage, **caractérisée en ce que** les entrées (30) de courant sont reliées aux bornes (26) électriques de la plaque (24) de montage par ou au moyen respectivement d'un ressort (28) hélicoïdal ou spiral conducteur de l'électricité, et le couvercle (16) comporte au moins un logement (40) de réception et de fixation amovible du ressort (28) hélicoïdal ou spiral.

2. Lampe de décharge basse pression suivant la revendication 1, **caractérisée en ce que** le ressort (28) hélicoïdal ou spiral vient pour la fermeture du contact entre l'entrée (30) de courant et la borne (26).

3. Lampe de décharge basse pression suivant la revendication 1, **caractérisé en ce que** le ressort (28) hélicoïdal ou spiral pousse, pour la fermeture du contact, l'entrée (30) de courant sur la borne (26).

4. Lampe de décharge basse pression suivant la revendication 2, **caractérisée en ce que** le logement (40) du ressort est constitué sur le pourtour intérieur du couvercle (16).

5. Lampe de décharge basse pression suivant la revendication 4, **caractérisée en ce que** le logement (40) du ressort comporte une cavité (42) de réception d'une partie du ressort (28) hélicoïdal ou spiral, cavité qui est constituée par une paroi (43) latérale de section transversale circulaire.

6. Lampe de décharge basse pression suivant la revendication 5, **caractérisée en ce que** la paroi (43) latérale comporte deux fentes (44a, 44b) opposées parallèlement, ouvertes vers l'extrémité libre du logement (40) pour le ressort et destinées à la réception de l'entrée (30) de courant.

7. Lampe de décharge basse pression suivant la revendication 6, **caractérisée en ce qu'**il est constitué dans la zone de la fente (44b) un épaulement (46) dans le couvercle (16) destiné à supporter une extrémité (56) de l'entrée (30) de courant.

8. Lampe de décharge basse pression suivant la revendication 3, **caractérisée en ce que** le logement (40) pour le ressort est constitué sur le pourtour intérieur du couvercle (16).

9. Lampe de décharge basse pression suivant la revendication 8, **caractérisée en ce que** le logement (40) pour le ressort comporte une cavité (42) de réception d'une partie du ressort (28) hélicoïdal ou spiral, cavité qui est constituée par une paroi (43) latérale de section transversale circulaire.

10. Lampe de décharge basse pression suivant l'une des revendications 8 ou 9, **caractérisée en ce qu'**il est constitué entre le pourtour intérieur du corps (18) et le logement (40) pour le ressort, une fente (48) de réception d'une extrémité (56) de l'entrée (30) de courant.

11. Lampe de décharge basse pression suivant l'une des revendications précédentes 8 à 10, **caractérisée en ce que** la paroi (43) latérale du logement (40) pour le ressort est prolongée en une partie (50) de façon que l'extrémité de la partie (50) de la paroi (43) latérale dépasse de la plaque (24) de montage ou la traverse dans la région du dispositif (32) de ballast, une fente (51) de réception de l'entrée (30) de courant étant constituée dans la partie (50).

12. Lampe de décharge basse pression suivant l'une des revendications précédentes, **caractérisée en ce que** la paroi (43) latérale entourant la cavité (42) comporte des biseaux (45) vers l'extrémité libre du logement (40) pour le ressort.

13. Lampe de décharge basse pression suivant l'une des revendications précédentes, **caractérisée en ce que** le ressort (28) est en un alliage métallique bon conducteur.

14. Lampe de décharge basse pression suivant l'une des revendications précédentes, **caractérisée en ce que** la longueur du ressort (48) est choisie de façon à assurer un contact sûr avec la borne (26) de la plaque (24) de montage.

15. Lampe de décharge basse pression suivant l'une des revendications précédentes, **caractérisée en ce que** le culot (12) est sensiblement de forme cylindrique.

16. Lampe de décharge basse pression suivant l'une des revendications précédentes, **caractérisée en ce que** le couvercle (16) et le corps (18) sont reliés entre eux de manière amovible, au moins un dispositif d'indexage étant prévu pour fixer correctement en position le couvercle (16) et le corps (18).

17. Lampe de décharge basse pression suivant l'une des revendications précédentes, **caractérisée en ce que** la plaque (24) de montage est fixée perpendiculairement à l'axe longitudinal de la lampe à l'intérieur du corps (18).

18. Lampe de décharge basse pression suivant l'une des revendication précédentes, **caractérisée en ce qu'**il est constitué sur le pourtour intérieur du corps (18) des nervures (58) qui s'étendent parallèlement à l'axe longitudinal de la lampe et aux extrémités desquelles s'applique la plaque (24) de montage.

19. Lampe de décharge basse pression suivant l'une des revendications précédentes, **caractérisée en ce que** la plaque (24) de montage est constituée en platine, des pistes conductrices étant constituées du côté tourné vers l'enceinte (14) de décharge et des éléments de circuit du dispositif (32) à ballast étant constitués sur le côté éloigné de l'enceinte (14) de décharge.

20. Lampe de décharge basse pression suivant l'une des revendications précédentes, **caractérisée en ce qu'**au moins une borne 26 est constituée en pastille de brasure pour le contact électrique des entrées (30) de courant avec la plaque (24) de montage.

21. Lampe de décharge basse pression suivant l'une des revendications précédentes, **caractérisée en ce qu'**au moins une borne (26), destinée au contact électrique des entrées (30) de courant avec la plaque de montage, est constituée d'une ou de plusieurs surfaces de brasure plates et/ou d'un ou de plusieurs rubans de brasure plats.

22. Lampe de décharge basse pression suivant l'une des revendications précédentes, **caractérisée en ce que** l'entrée (30) de courant et le ressort (28) sont d'un seul tenant.
